# FASCICULE DE BREVET EUROPEEN

(11) **EP 1 648 206 B1**
(45) Date de publication et mention de la délivrance du brevet: **19.09.2007**
(21) Numéro de dépôt: 05109146.0
(22) Date de dépôt: 03.10.2005
(51) Int. Cl.: H05K 1/02

(54) **Carte électronique à zone de contactage sinueuse**
Mit einer mäandrischen Kontaktierungszone versehene elektronische Karte
Electronic card with serpentine contacting zone

(30) Priorité: 08.10.2004 FR 0410636
(43) Date de publication de la demande: 19.04.2006
(73) Titulaire: MAGNETI MARELLI FRANCE, 92721 Nanterre (FR)
(72) Inventeur: Preteseille, Frédéric, 37290, Yzeures sur creuse (FR); Grohando, Claude, 86100, Chatellerault (FR)
(74) Mandataire: Branger, Jean-Yves

(56) Documents cités:
- EP-A- 0 710 062
- FR-A- 2 807 857
- US-B1- 6 297 458
- US-B1- 6 426 467
- ANONYMOUS: "Damascene test pad structure" RESEARCH DISCLOSURE, KENNETH MASON PUBLICATIONS, HAMPSHIRE, GB, vol. 322, no. 34, février 1991 (1991-02), XP007116042 ISSN: 0374-4353

## Description

La présente invention se rapporte à une carte électronique.

Cette carte est du type qui comporte des composants électroniques reliés par au moins une piste conductrice.

Ces cartes, dont les pistes sont traditionnellement en cuivre, sont recouvertes d'un vernis de protection organique. Elles comportent généralement une zone de contactage conductrice sans vernis de protection mais avec une passivation organique et connectée aux dites pistes.

Cette zone constitue en quelque sorte un prolongement du circuit constitué par les pistes et les composants, mais des fonctions particulières lui sont dévolues.

Ainsi, il est courant de contrôler la qualité d'un circuit imprimé équipé de composants électroniques, en particulier en sortie de chaîne de fabrication.

On utilise pour ce faire un appareil testeur qui envoie des signaux électriques aux composants du circuit pour mesurer les caractéristiques électriques, soit pour simuler des situations réelles, soit pour recevoir des signaux générés par les composants.

Les signaux enregistrés en réponse sont analysés par l'appareil testeur et permettent de contrôler si la carte remplit correctement les fonctions qu'on lui a attribuées et si les composants répondent à leurs caractéristiques électriques.

Le contact entre l'appareil testeur et la carte se fait par ladite zone de contactage, au moyen d'une ou plusieurs pointes métalliques et conductrices, solidaires de l'appareil.

Cette méthodologie est également utilisée lorsque l'on souhaite procéder à des mesures ou encore programmer le circuit électronique.

A chaque fois, on réalise un "contact" entre l'appareil de test, de mesure, de programmation, etc. et la carte, via ladite zone de contactage.

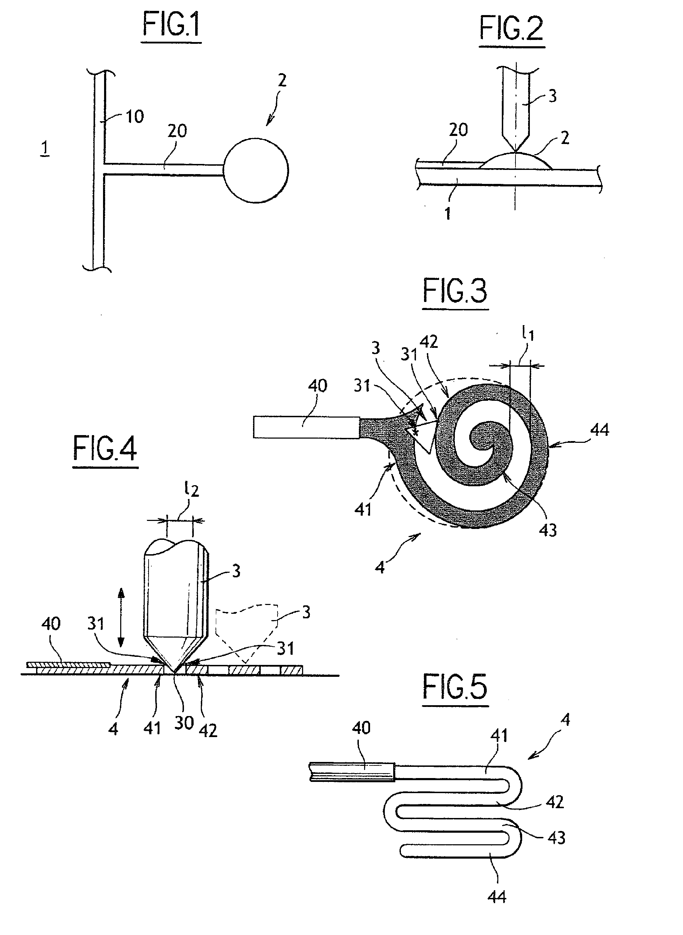

A la figure 1 est représentée schématiquement, vue de dessus, une forme de réalisation d'une telle zone et d'une portion du circuit auquel elle se raccorde, conformément à l'état de la technique.

La figure 2 représente, quant à elle, une vue de côté d'une telle zone, associée à une pointe d'un appareil de test.

Comme illustré à la figure 1, la carte électronique 1 comporte des composants électroniques (non visibles), reliés par au moins une piste conductrice 10. A cette piste est connectée une autre piste 20 qui débouche sur une zone de contactage 2.

Cette zone consiste en une pastille circulaire (voir figure 2) qui, tout comme les pistes 10 et 20, est de préférence constituée de cuivre passivé. Généralement un alliage de brasure (exemple alliage de plomb et d'étain) est déposé sur les zones de contactage 2 ce qui donne une forme bombée à celles-ci.

Pour réaliser un contact correct entre l'appareil testeur (ou autre) et la zone de contactage, on utilise une ou plusieurs pointes métalliques, du type de celle représentée à la figure 2.

Cette pointe 3 présente une extrémité inférieure en forme de pyramide inversée qui est mise en contact avec la zone 2.

Mais pour que le contact soit correct, il faut que l'extrémité de la pointe 3 touche et pénètre dans la couche d'alliage brasé.

On comprend aisément que ce contact se fera au mieux si la pointe est dirigée strictement perpendiculairement à la surface de la zone 2. Dans la pratique, ceci est loin d'être le cas, compte tenu de la forme bombée de la pastille et de la présence du flux.

Le document US-A-6 426 467 se rapporte à une carte électronique, dans laquelle une puce électronique est reliée à une série de pistes conductrices dont l'extrémité libre se termine par une pastille de test.

Certaines de ces pastilles sont disposées de manière à former des groupes d'au moins deux pastilles.

Elles sont disposées de manière adjacente, de façon à pouvoir être mises en contact simultanément avec la pointe d'un appareil de test.

La présente invention a pour but de pallier ces inconvénients en proposant une carte électronique telle que définie dans la revendication 1, et dont la zone de contactage permet d'assurer une connexion optimale entre les circuits qu'elle comporte et la ou les pointes de l'appareil de test (ou autre) qu'on se propose de mettre en place.

Cette carte électronique, est du genre qui comporte des composants électroniques reliés par au moins une piste conductrice, ainsi qu'au moins une zone de contactage également conductrice et connectée à ladite piste.

Conformément à l'invention, ladite zone de contactage présente un tracé sinueux, avec au moins deux parties en regard séparées par un intervalle dont la largeur est inférieure à la plus petite largeur d'une pointe de contactage sur ladite carte, de sorte que, quel que soit le point d'impact de ladite pointe sur ladite zone, cette pointe soit en contact avec une partie, voire deux parties en regard dudit tracé.

Grâce à cette structure, dès lors que la pointe va venir en contact avec ladite zone, son sommet va se trouver soit à l'aplomb du tracé proprement dit, soit dans un intervalle situé entre deux parties en regard.

Dans le premier cas, le contact s'établit directement par ce sommet.

Dans le second cas et dans la mesure où la largeur de l'intervalle est inférieure à la plus petite largeur d'une pointe, alors le contact entre la pointe et la zone de contactage va se faire par des zones périphériques de la pointe, situées en regard l'une de l'autre.

Selon un mode de réalisation préféré, ledit tracé a la forme d'une spirale.

Selon une autre variante, ledit tracé comporte plusieurs brins parallèles reliés deux à deux.

De préférence, ladite zone est en cuivre passivé.

D'autres caractéristiques et avantages de la présente invention apparaîtront à la lecture de la description détaillée qui va suivre, faite en référence aux dessins annexés dans lesquels :
- la figure 3 est une vue de dessus d'une première forme de réalisation de ladite zone de contactage, l'empreinte d'une pointe d'appareil de test y étant également représentée ;
- la figure 4 est une vue en coupe transversale de la zone de contactage de la figure 3, la pointe étant cette foi-ci représentée de face ;
- la figure 5 est une vue de dessus d'une variante de réalisation de ladite zone.

La zone de contactage 4 qui est représentée à la figure 3 est réalisée, comme le reste des connexions électriques de la carte, en cuivre passivé. Ces connexions sont traditionnellement revêtues d'une mince pellicule de vernis de protection d'origine organique.

Dans la forme de réalisation présentée ici, la zone 4 présente un tracé sinueux en forme de spirale, dont l'encombrement correspond sensiblement à celui qu'occupe la zone de contactage circulaire des cartes électroniques connues de l'état de la technique.

Cet encombrement est représenté par une ligne en traits interrompus.

L'épaisseur de cuivre qui constitue le tracé sinueux est la même que celle des connexions électriques de la carte.

On a référencé 1₁ la largeur de l'intervalle qui sépare deux parties en regard 43 et 44 du tracé.

Cette largeur 1₁ dépend du dessin et de la précision de la gravure mais est, dans la pratique, sensiblement égale à la largeur du dépôt de cuivre constituant le tracé.

Aux figures 3 et 4, la pointe 3 d'un appareil de test ou autre est représentée à l'aplomb d'une région de la zone 4 dans laquelle il n'y a pas de matière.

En d'autres termes, cela signifie que par un mouvement vertical de la pointe en direction de la carte, le sommet 30 de celle-ci vient en appui directement contre la carte, dans l'intervalle situé entre deux parties en regard 41 et 42 du tracé.

Cette situation est particulièrement visible à la figure 4. On notera que la pointe peut pénétrer partiellement le support électriquement isolant qui porte le tracé sinueux de la zone de contactage.

Conformément à l'invention, la largeur 1₁ de cet intervalle est inférieure à la plus petite largeur 1₂ de la pointe de contactage 3.

Comme montré à la figure 3, la section transversale de la pointe 3 a la forme d'un triangle isocèle, de sorte que la largeur 1₂ (hauteur de la section triangle isocèle de la pointe) à la position de contactage soit toujours supérieure à 1₁.

De ce fait, la région de la pointe 3 qui entoure son sommet 30 vient en contact en deux points 31 avec deux parties en regard 41 et 42 du tracé 4.

En traits interrompus à la figure 4 est représentée la situation dans laquelle la pointe 3 vient en contact direct avec le tracé sinueux 4. Ce contact est réalisé directement au niveau du sommet 30.

A la figure 5 est représentée une variante de la zone de contactage. Son tracé comporte ici plusieurs brins parallèles 41 à 44 reliées par des régions courbes, à la manière d'un serpentin.

Grâce à la structure de la zone de contactage selon l'invention, on utilise moins de matière qu'avec les zones traditionnelles "pleines" et à contour circulaire. Un contact direct est établi entre la pointe et le cuivre.

Un bon contact entre la pointe et la zone est assuré par la diminution de résistance mécanique sous ladite pointe. Le contact ainsi assuré est stable.

Ce contact se fait toujours selon des directions perpendiculaires, ce qui garantit une parfaite connexion électrique, d'où moins d'erreurs.

Ce contact est visuellement matérialisé sur le cuivre par un ou deux points correspondant à l'impact de la pointe.

On a donc une parfaite visibilité du contact ainsi établi.

Enfin, du fait de l'absence de flux et l'alliage de brasure, une telle zone de contactage nécessite une maintenance moins fréquente.

Le cas échéant, la pointe de mesure, test ou contactage peut comporter plusieurs extrémités pointues.

## Revendications

1. Carte électronique, qui comporte des composants électroniques reliés par au moins une piste conductrice (10), ainsi qu'au moins une zone de contactage (4) également conductrice et connectée à ladite piste (10), **caractérisée par le fait que** ladite zone de contactage (4) présente un tracé sinueux, avec au moins deux parties en regard (41, 42 ; 43, 44) séparées par un intervalle (I₁) dont la largeur est inférieure à la plus petite largeur d'une pointe (I₂) de contactage sur ladite carte, de sorte que, quel que soit le point d'impact de ladite pointe (3) sur ladite zone, cette pointe soit en contact avec une partie (41 ; 42 ; 43 ; 44), voire deux parties en regard (41, 42 ; 43, 44) dudit tracé.

2. Carte électronique selon la revendication 1, **caractérisée par le fait que** ledit tracé a la forme d'une spirale.

3. Carte électronique selon la revendication 1, **caractérisée par le fait que** ledit tracé comporte plusieurs brins parallèles (41, 42, 43, 44) reliés deux à deux.

4. Carte électronique selon l'une des revendications 1 à 3, **caractérisée par le fait que** ladite zone (4) est en cuivre passivé.

## Claims

1. An electronic card that includes electronic components interconnected by at least one conductive track (10), and at least one contact zone (4) that is likewise conductive and that is connected to said track (10), the card being **characterized by** the fact that said contact zone (4) presents a sinuous trace, with at least two facing portions (41, 42; 43, 44) separated by a gap (ℓ₁) of width narrower than the narrowest width of a contact tip (ℓ₂) for contacting said card, such that regardless of the point of impact of said tip (3) on said zone, said tip comes into contact with one or two facing portions (41, 42; 43, 44) of said trace.

2. An electronic card according to claim 1, **characterized by** the fact that said trace is of spiral shape.

3. An electronic card according to claim 1, **characterized by** the fact that said trace comprises a plurality of parallel strands (41, 42, 43, 44) interconnected in pairs.

4. An electronic card according to any one of claims 1 to 3, **characterized by** the fact that said zone (4) is made of passivated copper.

## Patentansprüche

1. Elektronische Karte, die folgendes umfaßt: elektronische Komponenten, die durch wenigstens eine Leiterbahn (10) verbunden sind, sowie wenigstens eine Kontaktzone (4), die ebenfalls leitend und mit der Leiterbahn (10) verbunden ist, **dadurch gekennzeichnet, daß** die Kontaktzone (4) eine gewundene Spur hat, mit wenigstens zwei sich gegenüberliegenden Abschnitten (41, 42; 43, 44), die durch einen Abstand (l₁) getrennt sind, dessen Breite geringer ist als die kleinste Breite einer Spitze (l₂) zur Kontaktgebung auf der Karte, derart, daß unabhängig vom Auftreffpunkt der Spitze (3) auf der Zone, diese Spitze mit einem Abschnitt (41; 42; 43; 44) oder sogar mit zwei sich gegenüberliegenden Abschnitten (41, 42; 43, 44) der Spur in Kontakt ist.

2. Elektronische Karte nach Anspruch 1, **dadurch gekennzeichnet, daß** die Spur die Form einer Spirale hat.

3. Elektronische Karte nach Anspruch 1, **dadurch gekennzeichnet, daß** die Spur mehrere parallele Adern (41, 42, 43, 44) umfaßt, die paarweise miteinander verbunden sind.

4. Elektronische Karte nach einem der Ansprüche 1 bis 3, **dadurch gekennzeichnet, daß** die Zone (4) aus passiviertem Kupfer ist.
